Europäisches Patentamt

(19) European Patent Office

Office européen des brevets

(11) EP 0 613 571 B1

## (12) EUROPEAN PATENT SPECIFICATION

(45) Date of publication and mention
of the grant of the patent:
**29.07.1998 Bulletin 1998/31**

(21) Application number: **93918815.7**

(22) Date of filing: **17.09.1993**

(51) Int Cl.$^6$: **G02F 1/313**, G02F 1/025,
H01S 3/085

(86) International application number:
**PCT/BE93/00061**

(87) International publication number:
**WO 94/07178 (31.03.1994 Gazette 1994/08)**

(54) **INTEGRATED TUNABLE OPTICAL FILTER**

INTEGRIERTES ABSTIMMBARES OPTISCHES FILTER

FILTRE OPTIQUE ACCORDABLE INTEGRE

(84) Designated Contracting States:
**AT BE CH DE DK ES FR GB GR IE IT LI LU NL PT
SE**

(30) Priority: **24.09.1992 BE 9200838**

(43) Date of publication of application:
**07.09.1994 Bulletin 1994/36**

(73) Proprietor: **INTERUNIVERSITAIR
MICROELEKTRONICA CENTRUM VZW
3001 Leuven (BE)**

(72) Inventors:
• **WILLEMS, Jan
B-9050 Gentbrugge (BE)**
• **BAETS, Roel
B-9800 Deinze (BE)**

(74) Representative: **Vanderperre, Robert et al
Bureau Vander Haeghen S.A.
Rue Colonel Bourg 108 A
1030 Bruxelles (BE)**

(56) References cited:
• **APPLIED PHYSICS LETTERS. vol. 60, no. 8 ,
February 1992 , NEW YORK US pages 980 - 982
R.C.ALFERNESS & ALL 'BROADLY TUNEBLE
INGAASP/INP BURIED RIB WAVEGUIDE
VERTICAL COUPLER FILTER' cited in the
application**
• **PATENT ABSTRACTS OF JAPAN vol. 016, no.
297 (E-1226)30 June 1992 & JP,04 079 287
(CANON)**
• **APPLIED PHYSICS LETTERS. vol. 60, no. 19 , 11
May 1992 , NEW YORK US pages 2321 - 2323
V.JAYARAMAN & ALL 'DEMONSTRATION OF
BROADBAND TUNABILITY IN A
SEMICONDUCTOR LASER USING SAMPLED
GRATINGS' cited in the application**
• **IEEE JOURNAL OF QUANTUM ELECTRONICS.
vol. 24, no. 2 , February 1988 , NEW YORK US
pages 143 - 147 N.A. OLSSON 'PERFORMANCE
CHARACTERISTICS OF A ......'**
• **ELECTRONICS LETTERS. vol. 27, no. 22 ,
October 1991 , ENAGE GB pages 2050 - 2051
T.HIRATA 'MONOLITHIC RESONANT OPTICAL
REFLECTOR LASER DIODES'**
• **18TH EUROPEAN CONFERENCE ON OPTICAL
COMMUNICATION vol. 1 , 27 September 1992 ,
BERLIN DE pages 413 - 416 J.WILLEMS & AL
'NOVEL WIDELY TUNABLE INTEGRATED
OPTICAL FILTER WITH HIGH SPECTRAL
SELECTIVITY'**

# Description

Background of the invention

The invention relates to an integrated broadly tunable optical filter designed, in particular, for advanced WDM (Wavelength Division Multiplexing) applications as well as for use in spectroscopic testing of various optical components.

Broadly tunable optical filters are key components in optical communication systems. Two objectives dominate with such filters. The aims, on the one hand, are a broad tunable range and, on the other hand, high spectral selectivity. The planar integrated structures known hitherto, however, permit only one of these objectives at a time to be met.

A conventional filter structure, known as codirectional coupler structure, is described in "Broadly tunable InGaAsP/InP buried rib waveguide vertical coupler filter" (R.C. Alferness, L.L. Buhl, U. Koren, B.I. Miller, M. G. Young, T.L. Koch, G.A. Burrus, G. Raybon), Appl. Phys. Lett. 60(8), 24 February 1992. This conventional structure consists of two asymmetrical waveguides having different effective refractive indices. The optical signal launched into the uppermost waveguide is launched into the lowermost waveguide and selectively reflected towards the uppermost waveguide. If the parameters of the waveguides are chosen carefully, a structure of this type can act as a selective filter.

The advantage of this conventional structure is the fact that a broad tuning range is provided, but it is difficult to obtain high spectral selectivity without constructing a long appliance.

On the other hand, a semiconductor optical structure is also known which can provide high selectivity. This conventional structure makes use of a waveguide having a grating grown thereon, that grating of which is periodically omitted. A structure of this type has already been used in a tunable laser (V. Jayaraman, D.A. Cohen, L.A. Coldren, "Demonstration of broadband tunability in a semiconductor laser using sampled gratings", Appl. Phys. Lett 60(19), 11 May 1992). Nevertheless, a structure of this type has hitherto not been used in a filter structure.

This conventional structure provides a comb-shaped reflection spectrum. The parameters thereof are the spacing between the peaks, the spectral bandwidth of the envelope of the comb spectrum, the peak maximums and the bandwidth of a reflection peak. The latter is probably the most important parameter, because it affects the selectivity of the structure. Most unfortunately, this parameter too limits the tuning range of the structure.

Summary of the invention

The object of the present invention is to present an opitcal filter structure which provides, at the same time, a large tuning range and high spectral selectivity in a compact integrated applicance.

In order to accomplish the abovementioned objective, the present invention provides an integrated optical filter comprising a substrate made of a semiconductor material, the substrate comprising a first section forming a tunable filter element having a single broad spectral response peak, the filter further comprising first means adapted to inject current into said first section to thereby shift in wavelength the spectral response peak of said tunable filter element, the integrated tunable optical filter being characterized in that the substrate further comprises a second section forming a selectively reflecting device having a plurality of narrow spectral response peaks, in that the filter further comprises second means adapted to inject current into said second section to thereby slightly shift in wavelength the spectral response peaks of said selectively reflecting device and in that the spectral response functions of said tunable filter element and said selectively reflecting element are such that when one of the spectral response peaks of the selectively reflecting device coincides with the centre of the spectral response peak of the tunable filter element only that response peak of the selectively reflecting device falls within the spectral response peak of the tunable filter element, so that the spectral filter response of the integrated tunable optical filter has a single narrow peak.

The first section forms a codirectional optical coupler, comprising a first and a second waveguide having a first part of a grating therebetween, a first electrode on the topside of said first section and a back electrode on the underside thereof.

The second section comprises a waveguide coupled with said first waveguide in the first section and having a periodically broken reflection structure which is formed on said waveguide, a second electrode on the topside of said second section and a back electrode on the underside thereof.

In a particular embodiment, the first part of the grating has a period of 10-50 µm. The reflection structure in the second section comprises a second part of said grating with regions which have a period less than that of said first part of said grating.

Brief description of the drawings

The invention will be explained in more detail with reference to the drawing, in which

Figure 1          diagrammatically represents a cross section of the structure according to the invention;

Figures 2 to 6          inclusive represent curves, by way of example, which illustrate the operation of the filter structure of Figure 1.

Detailed description

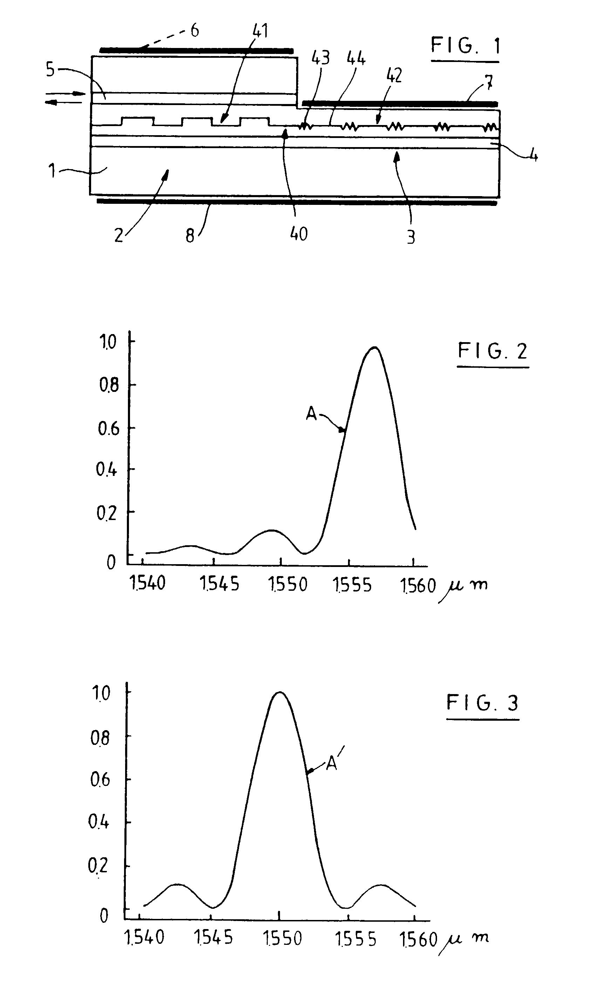

Figure 1 shows an optical filter structure according to the invention. The integrated filter structure mainly comprises a substrate 1 made of semiconductor material, for example InP, in which two sections 2 and 3 are formed. On the substrate a number of layers are grown from semiconductor material, for example InGaAsP, which form the lowermost waveguide 4 having a grating 40 grown thereon. Said grating 40 is grown so as to have two different geometrical structures, namely a first rib-shaped structure 41 having a long period in said first section 2, and a second periodically broken sawtooth-shaped or stripe-shaped structure 42 in said second section 3. The lastmentioned sawtooth-shaped structure 42 is formed so as to have short-period striped regions 43 and alternating non-striped regions 44. Typical values for the period of the rib-shaped structure range between 10 and 50 μm, inclusive. Typical values for the period of the sawtooth-shaped structure are below 1 μm.

At the top of the first rib-shaped structure 41, and at a distance therefrom, an uppermost waveguide 5 extends in such a way that there is formed, in the first section 2 of the substrate, a codirectional coupler section. On the topside of the first section 2 there is provided a first electrode 6, by means of which injection current can be coupled into said first section. On the topside of the second section 3, too, a second electrode 7 is provided by means of which injection current can be coupled into said second section. A common back electrode 8 is provided on the underside of the substrate.

An appliance according to the invention works as follows. An optical signal is passed into the uppermost waveguide 5, and at a certain wavelength λ, 100 % of the optical power is coupled across to the lowermost waveguide 4. The spectral bandwidth of the codirectional coupler in section 2 is determined by the length $L_{codir}$ of said section 2, the period of the rib-shaped structure 41 and the effective refractive indices $n_a$ and $n_b$ of the two waveguides 5 and 4, respectively, according to the following relationship:

$$\Delta\lambda_{3dB} = 0.8 \frac{\Lambda}{L_{codir}} \frac{\lambda}{1-\Lambda \frac{\partial}{\partial\lambda}(n_b - n_a)}$$

Said coupled wavelength can be altered by varying the refractive indices $n_a$ and $n_b$ based on current injection by applying a voltage between electrodes 6 and 8. Figure 2 represents an example of a filter response A of a codirectional coupler, and Figure 3 represents the same filter response A', but shifted in wavelength by current injection. It should be noted that the filter response in section 2 has a low selectivity.

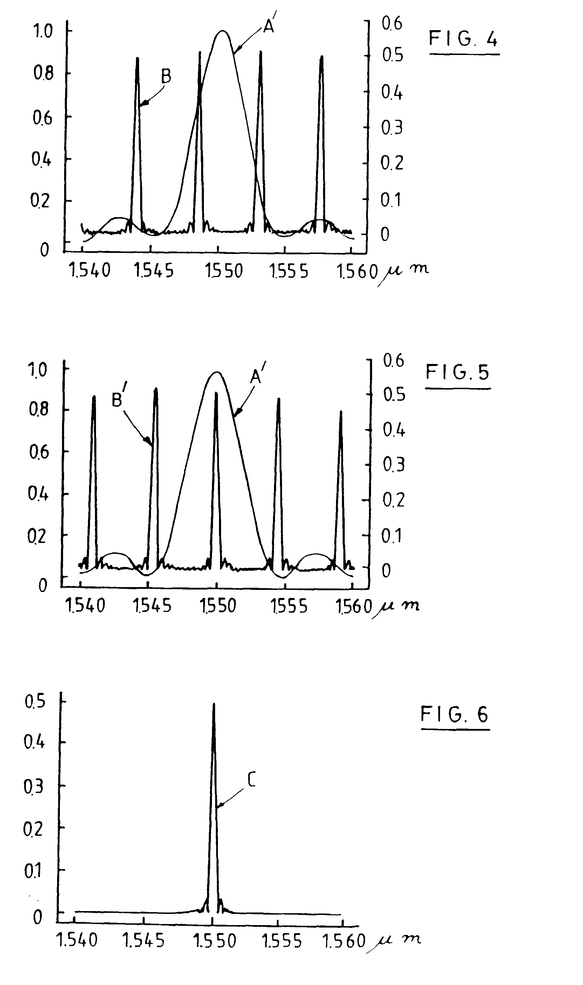

The optical signal which was coupled to the lowermost waveguide 4 ends up in the broken sawtooth-shaped structure 42. The reflection spectrum of said structure is comb-shaped as shown by B in Figure 4, together with the filter response of the first section. The reflection peaks of the comb spectrum have a high selectivity. The selectivity is mainly determined by the number of periods in the broken structure 42 and the coupling strength of that structure.

The reflection peaks of the comb spectrum B can be changed slightly by current injection in said section when a voltage is applied between electrodes 7 and 8. Thus the comb spectrum is slightly shifted in wavelength as shown by B' in Figure 5. Thus it is possible to ensure that the wavelength of one of the reflection peaks corresponds to the central coupling wavelength of the first section 2.

This results in a filter response C having a very narrow bandwidth as shown in Figure 6, which response is launched into the uppermost waveguide 5 and supplied to the output thereof.

The parameters of the two sections 2 and 3 cannot be chosen totally independently of one another, but must satisfy at least the following condition. This condition establishes a relationship between the spectral bandwidth of the codirectional coupler and the spacing between the peaks in the comb spectrum of section 3. This bandwidth must be smaller than the spacing between the peaks:

$$\Delta\lambda_{3dB} < \frac{\lambda^2}{2\,n(L_1 + L_2)}$$

where $\Delta\lambda_{3dB}$ is the spectral bandwidth of the codirectional coupler:

$$\Delta\lambda_{3dB} = 0.8 \frac{\Lambda}{L_{codir}} \frac{\lambda}{1-\Lambda \frac{\partial}{\partial\lambda}(n_b - n_a)}$$

where:

| | |
|---|---|
| λ | is the wavelength, |
| Λ | is the period of the rib-shaped structure in the first section |
| $L_{codir}$ | is the length of the first section |
| $n_a$, $n_b$ | are the effective refractive indices of the two waveguides in the first section, |
| $L_1$ | is the length of the sawtooth-shaped structure grating in one period of the second section, |
| $L_2$ | is the length of the non-striped portion of the grating structure in one period of the second section, |
| n | is the effective refractive index of the waveguide in the second section. |

Furthermore, the choice of the parameters is also restricted by the properties required of the overall structure. Two important properties are the magnitude of the tuning range and the selectivity. The tuning range is determined by both sections and is no greater than the maximum of two variables, namely $\Delta\lambda_1$, the tuning range of the codirectional structure, and $\Delta\lambda_2$, the spectral bandwidth of the envelope of the comb spectrum at the

$$\Delta\lambda_1 = \Lambda \frac{\Delta(n_b - n_a)}{1 - \Lambda \frac{\partial}{\partial\lambda}(n_b - n_a) \times \Lambda \Delta \frac{\partial}{\partial\lambda}(n_b - n_a)}$$

$$\Delta\lambda_2 = \frac{I \lambda^2}{L_1 \pi n} \sqrt{2}$$

Typical values in one illustrative embodiment in an InGaAsP substrate:

| Codirectional coupler section | |
|---|---|
| Length $L_{codir}$ | 900 µm |
| $n_a$ | 3.210 |
| $n_b$ | 3.307 |
| $\Lambda$ | 16 µm |
| Coupling coefficient | 17.5 cm⁻¹ |

| Broken sawtooth-shaped structure | |
|---|---|
| Length | 900 µm |
| $N_{eff}$ | 3.24 |
| $L_1$ | 75 µm |
| $L_2$ | 7.5 µm |
| $\Lambda$samgrat | 0.2413 µm |
| Coupling coefficient | 10 cm⁻¹ |

| Filter response | |
|---|---|
| Central wavelength | $\lambda = 1.550$ µm |
| Tuning range | 50 nm |
| Change of refractive index | 0.3 nm |

## Claims

1. Integrated optical filter comprising a substrate (1) made of a semiconductor material, the substrate comprising a first section (2) forming a tunable filter element having a single broad spectral response peak, the filter further comprising first means adapted to inject current into said first section (2) to thereby shift in wavelength the spectral response peak of said tunable filter element, the integrated tunable optical filter being characterized in that the substrate (1) further comprises a second section (3) forming a selectively reflecting device having a plurality of narrow spectral response peaks, in that the filter further comprises second means adapted to inject current into said second section (3) to thereby slightly shift in wavelength the spectral response peaks of said selectively reflecting device and in that the spectral response functions of said tunable filter element and said selectively reflecting element are such that when one of the spectral response peaks of the selectively reflecting device coincides with the centre of the spectral response peak of the tunable filter element only that response peak of the selectively reflecting device falls within the spectral response peak of the tunable filter element, so that the spectral filter response of the integrated tunable optical filter has a single narrow peak.

2. Optical filter according to Claim 1, characterized, in that said first section (2) forms a codirectional optical coupler, comprising a first (4) and a second (5) waveguide having a first part (41) of a grating (40) therebetween, a first electrode (6) on the topside of said first section and a back electrode (8) on the underside thereof.

3. Optical filter according to Claim 2, characterized in that said first part of said grating has a period of 10-50 µm.

4. Optical filter according to Claim 1, 2 or 3, characterized in that said second section (3) comprises a waveguide coupled with said first waveguide (4) in the first section and having a periodically broken reflection structure (42) which is formed on said waveguide, a second electrode (7) on the topside of said second section and a back electrode (8) on the underside thereof.

5. Optical filter according to Claim 4, characterized in that said reflection structure (42) comprises a second part of said grating with regions (43) which have a period less than that of said first part (41) of said grating.

6. Optical filter according to Claim 4 or 5, characterized in that said first waveguide (4) and the waveguide in said second section (3) are formed from the same layer.

7. Optical filter according to any one of Claims 2 to 6 inclusive, characterized in that said back electrode (8) on the underside of both sections is a common back electrode.

## Patentansprüche

1. Integriertes optisches Filter, welches ein aus einem Halbleitermaterial hergestelltes Substrat (1) umfaßt, wobei das Substrat einen ersten Abschnitt (2) umfaßt, welcher ein abstimmbares Filterelement bildet, das einen einzelnen breiten spektralen Antwortsignalpeak aufweist, wobei überdies das Filter ein erstes Mittel umfaßt, welches ausgelegt ist, um Strom in den ersten Abschnitt (2) zu injizieren, um dadurch die Wellenlänge des spektralen Antwortsignalpeaks des abstimmbaren Filterelements zu verschieben, wobei das integrierte abstimmbare optische Filter dadurch gekennzeichnet ist, daß das Substrat (1) überdies einen zweiten Abschnitt (3) umfaßt, welcher eine selektiv reflektierende Vorrichtung bildet, welche eine Vielzahl von Antwortsignalpeaks mit schmaler Bandbreite aufweist, darin, daß das Filter weiter ein zweites Mittel umfaßt, welches ausgelegt ist, Strom in den zweiten Abschnitt (3) zu injizieren, um dadurch die Wellenlängen der spektralen Antwortsignalpeaks der selektiv reflektierenden Vorrichtung etwas zu verschieben, und darin, daß die spektralen Antwortfunktionen des abstimmbaren Filterelements und des selektiv reflektierenden Elements derart sind, daß, wenn eines der spektralen Antwortsignalpeaks der selektiv reflektierenden Vorrichtung mit der Mitte des spektralen Antwortsignalpeaks des abstimmbaren Filterelements zusammenfällt, nur dieses Antwortsignal der selektiv reflektierenden Vorrichtung in den spektralen Antwortsignalpeak des abstimmbaren Filterelements fällt, so daß die spektrale Filterantwort des integrierten abstimmbaren optischen Filters einen einzelnen schmalen Signalpeak aufweist.

2. Optisches Filter nach Anspruch 1, dadurch gekennzeichnet, daß der erste Abschnitt (2) einen codirektionalen optischen Koppler bildet, welcher einen ersten (4) und einen zweiten (5) Wellenleiter umfaßt, welche einen ersten Teil (41) eines Gitters (40) dazwischen, eine erste Elektrode (6) auf der Oberseite und eine hintere Elektrode (8) an deren Unterseite aufweisen.

3. Optisches Filter nach Anspruch 2, dadurch gekennzeichnet, daß der erste Teil des Gitters eine Periode von 10-50 µm aufweist.

4. Optisches Filter nach Anspruch 1, 2 oder 3, dadurch gekennzeichnet, daß der zweite Abschnitt (3) einen Wellenleiter, der mit dem ersten Wellenleiter (4) im ersten Abschnitt gekoppelt ist und eine periodisch unterbrochene, auf dem Wellenleiter ausgeformte Reflexionsstruktur (42) aufweist, eine zweite Elektrode (7) auf der Oberseite des zweiten Abschnitts und eine hintere Elektrode (8) an dessen Unterseite umfaßt.

5. Optisches Filter nach Anspruch 4, dadurch gekennzeichnet, daß die Reflexionsstruktur (42) einen zweiten Teil des Gitters mit Bereichen (43) umfaßt, welche eine geringere Periode aufweisen als jene des ersten Teils (41) des Gitters.

6. Optisches Filter nach Anspruch 4 oder 5, dadurch gekennzeichnet, daß der erste Wellenleiter (4) und der Wellenleiter im zweiten Abschnitt (3) aus derselben Schicht gebildet werden.

7. Optisches Filter nach irgendeinem der Ansprüche 2 bis einschließlich 6, dadurch gekennzeichnet, daß die hintere Elektrode (8) auf der Unterseite beider Abschnitte eine gemeinsame hintere Elektrode ist.

## Revendications

1. Filtre optique intégré comprenant un substrat (1) fait d'un matériau semiconducteur, le substrat comprenant une première section (2) formant un élément de filtre accordable ayant un seul pic de réponse spectrale large, le filtre comprenant en outre un premier moyen agencé pour injecter un courant dans ladite première section (2) de manière à changer la longueur d'onde du pic de réponse spectrale de l'élément de filtre accordable précité, le filtre optique accordable intégré étant caractérisé en ce que le substrat (1) comprend en outre une seconde section (3) formant un dispositif réfléchissant sélectif ayant plusieurs pics de réponse spectrale étroite, en ce que le filtre comprend en outre un second moyen agencé pour injecter un courant dans ladite seconde section (3) afin de changer légèrement la longueur d'onde des pics de réponse spectrale du dispositif réfléchissant sélectif, et en ce que les fonctions de réponse spectrale dudit élément de filtre accordable et dudit dispositif réfléchissant sélectif sont telles que lorsqu'un des pics de réponse spectrale du dispositif réfléchissant sélectif coïncide avec le milieu du pic de réponse de l'élément de filtre accordable, seul ce pic de réponse du dispositif réfléchissant sélectif tombe dans le pic de réponse spectrale de l'élément de filtre accordable, de manière que la réponse spectrale du filtre optique accordable intégré ait un seul pic étroit.

2. Filtre optique suivant la revendication 1, caractérisé en ce que la première section (2) forme un coupleur optique codirectionnel comprenant un premier guide d'onde (4) et un second guide d'onde (5) ayant une première partie (4') de grille (40), une première électrode (6) sur la face supérieure de ladite première section et une contre-électrode (8) sur la face inférieure de ladite section.

3. Filtre optique suivant la revendication 2, caractérisé en ce que ladite première partie de la grille a une période de 10-50 µm.

**4.** Filtre optique suivant la revendication 1, 2 ou 3, caractérisé en ce que ladite seconde section (3) comprend un guide d'onde couplé audit premier guide d'onde (4) de la première section et ayant une structure de réflexion périodiquement interrompue (42) qui est formée sur ledit guide d'onde, une seconde électrode (7) sur la face supérieure de ladite seconde section et une contre-électrode (8) sur la face inférieure de ladite section.

**5.** Filtre optique suivant la revendication 4, caractérisé en ce que la structure de réflexion (42) précitée comprend une seconde partie de la grille précitée qui présente des régions (43) qui ont une période plus petite que celle de ladite première partie (41) de la grille précitée.

**6.** Filtre optique suivant la revendication 4 ou 5, caractérisé en ce que le premier guide d'onde (4) et le guide d'onde de la seconde section (3) précitée sont formés dans la même couche.

**7.** Filtre optique suivant l'une quelconque des revendications 2 à 6, caractérisé en ce que la contre-électrode (8) sur la face inférieure des deux sections est une contre-électrode commune.

FIG. 1

FIG. 2

FIG. 3

FIG. 4

FIG. 5

FIG. 6